Europäisches Patentamt

European Patent Office

Office européen des brevets

(19)

(11) EP 1 160 906 A1

(12) EUROPEAN PATENT APPLICATION
published in accordance with Art. 158(3) EPC

(43) Date of publication:
05.12.2001 Bulletin 2001/49

(51) Int Cl.$^7$: H01P 1/18, H03H 11/20

(21) Application number: 99973764.6

(86) International application number:
PCT/JP99/06485

(22) Date of filing: 19.11.1999

(87) International publication number:
WO 00/54362 (14.09.2000 Gazette 2000/37)

(84) Designated Contracting States:
AT BE CH CY DE DK ES FI FR GB GR IE IT LI LU
MC NL PT SE
Designated Extension States:
AL LT LV MK RO SI

(30) Priority: 05.03.1999 JP 5933099

(71) Applicant: NEC Corporation
Minato-ku, Tokyo 108-8001 (JP)

(72) Inventor: NAKADA, Kuniyoshi NEC Corporation
Minato-ku, Tokyo 108-8001 (JP)

(74) Representative: VOSSIUS & PARTNER
Siebertstrasse 4
81675 München (DE)

(54) **PHASER**

(57) A phase shifter includes a fixed-length transmission line (103) with an electrical length of 180° having one end connected to an end of an input/output transmission line (101), a first variable-length transmission line (104) connected to the other end of the fixed-length transmission line, a second variable-length transmission line (105) connected to an end of an input/output transmission line (102), switches (112, 122) for switching electrical lengths of the variable-length transmission lines (104, 105), switch means (106), including at least two switches (131, 132), for switchingly connecting the end of the input/output transmission line (102) to one or the other end of the fixed-length transmission line, so that an RF signal has a phase shift amount of 0° or 180°, and a control means (107) for controlling the switches (112, 122, 131, 132). The phase shifter can thus downsized.

F I G . 1

EP 1 160 906 A1

**Description**

Technical Field

The present invention relates to a phase shifter and, more particularly, to a digital phase shifter in a microwave band and milliwave band which is used for phase control of, e.g., a phased array antenna.

Background Art

Usually, in a digital phase shifter used in a phased array antenna, a plurality of phase shifters with different phase differences (e.g., 180°, 90°, 45°, 22.5°,...) are cascade-connected to implement a phase of a plurality of bits.

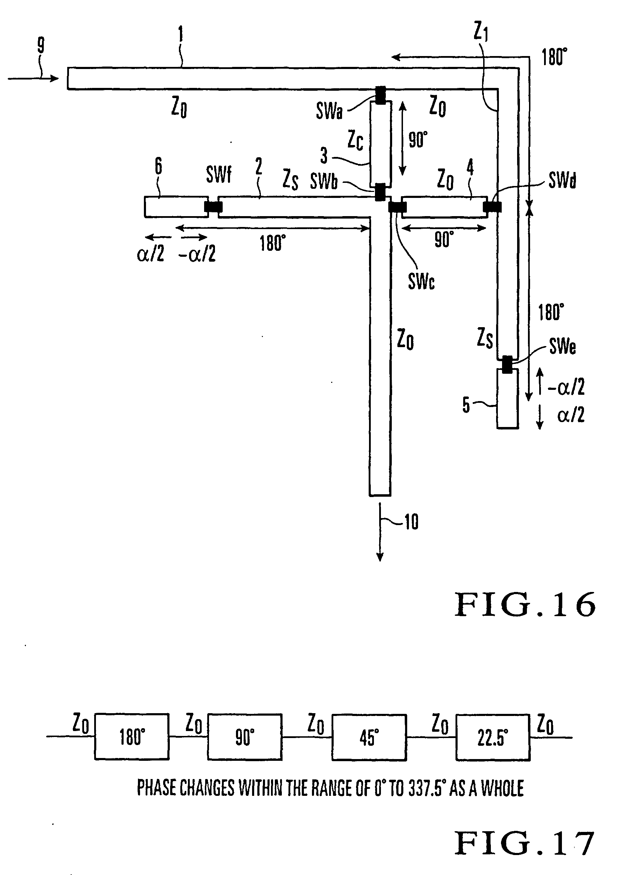

Fig. 17 is a block diagram showing a conventional 4-bit phase shifter. As shown in Fig. 17, this phase shifter has four cascade-connected phase shifters of 180°, 90°, 45°, and 22.5° so that it can implement a phase change of 0° to 337.5° as a whole.

In this prior art, since the phase shifters of the respective bits require spaces between them so that they do not interfere with each other, and the whole phase shifter size becomes large.

The present invention has been made to solve this problem, and has as its object to provide a phase shifter which is more compact than a conventional one.

Disclosure of Invention

In order to achieve the above object, according to the present invention, a phase shifter for digitally phase-shifting an RF signal comprises two input/output transmission lines (101, 102) arranged such that ends thereof are apart from each other, a first fixed-length transmission line (103) with an electrical length of 180° having one end connected to an end of one (101) of the input/output transmission lines, a first variable-length transmission line (104) connected to the other end of the first fixed-length transmission line, a second variable-length transmission line (105) connected to an end of the other one (102) of the input/output transmission lines, first switches (112, 122) respectively included in the first and second variable-length transmission lines to switch electrical lengths of the first and second variable-length transmission lines, switch means (106), including at least two switches (131, 132), for switchingly connecting the end of the other input/output transmission line to one or the other end of the first fixed-length transmission line, so that the RF signal has a phase shift amount of 0° or 180°, and control means (107) for controlling the first switches included in the first and second variable-length transmission lines and the switches included in the switch means.

In this case, according to one arrangement, the switch means has second and third fixed-length transmission lines (3, 4) arranged apart from two ends of the first fixed-length transmission line and from the end of the other input/output transmission line, a second switch (SWa) for connecting one end of the second fixed-length transmission line and one end of the first fixed-length transmission line, a third switch (SWb) for connecting the other end of the second fixed-length transmission line and the end of the other input/output transmission line, a fourth switch (SWd) for connecting one end of the third fixed-length transmission line and the other end of the first fixed-length transmission line, and a fifth switch (SWc) for connecting the other end of the third fixed-length transmission line and the end of the other input/output transmission line, and the control means includes means for complimentarily driving the second and third switches and the fourth and fifth switches included in the switch means.

According to another arrangement, the switch means has a second fixed-length transmission line (14) with open one end and the other end connected to the end of the other input/output transmission line, a sixth switch (SWg) for connecting one end of the second fixed-length transmission line and one end of the first fixed-length transmission line, and a seventh switch (SWh) for connecting one end of the second fixed-length transmission line and the other end of the first fixed-length transmission line, and the control means includes means for complimentarily driving the sixth and seventh switches included in the switch means.

According to the present invention, there is provided another phase shifter for digitally phase-shifting an RF signal, comprising first phase shifting means, having a first transmission line (4), a first variable-length transmission line (part of the transmission line 1 + transmission line 5) connected to one end of the first transmission line, a second variable-length transmission line (part of the second transmission line 2 + transmission line 6) connected to the other end of the first transmission line, and a second transmission line (part of the transmission line 1) with an electrical length of 180° and connected to one end of the first transmission line, for switching line lengths of the first and second variable-length transmission lines at the two ends of the first transmission line, thereby performing phase shifting, second phase shifting means, having a third transmission line (3), a series circuit connected to one end of the third transmission line and comprised of the second transmission line and the first variable-length transmission line, and the second variable-length transmission line connected to the other end of the third transmission line, for switching line lengths of the first and second variable-length transmission lines at the two ends of the third transmission line, thereby performing phase shifting, and switching means (switches SWa, SWb, SWc, SWd) for switching the first and second phase shifting means with each other.

According to the present invention, there is provided still another phase shifter comprising first phase shifting means, having a first transmission line (14), a first variable-length transmission line (15, 17) connected to one end of the first transmission line, a second variable-length transmission line (16, 18) connected to the other end of the first transmission line, and a second transmission line (13) with an electrical length of 180° and connected to one end of the first transmission line, for switching line lengths of the first and second variable-length transmission lines at the two ends of the first transmission line, thereby performing phase shifting, second phase shifting means, having the first transmission line, a series circuit connected to one end of the first transmission line and comprised of the second transmission line and the first variable-length transmission line, and the second variable-length transmission line connected to the other end of the first transmission line, for switching line lengths of the first and second variable-length transmission lines at the two ends of the first transmission line, thereby performing phase shifting, and switching means (switches SWg, SWh) for switching the first and second phase shifting means with each other.

Each of the first and second variable-length transmission lines may have a first switch connected between a fourth transmission line and a fifth transmission line with an open distal end.

Each of the first and second varible-length transmission lines may have a first switch with one grounded end, which is connected between a fourth transmission line and a fifth transmission line with an open distal end.

Each of the first and second varible-length transmission lines may have a first switch connected between a fourth transmission line and a fifth transmission line with a grounded distal end.

Each of the first and second varible-length transmission lines may have a first switch with one end grounded, which is connected between a fourth transmission line and a fifth transmission line with a grounded distal end.

The phase shifter may further comprise signal input/output sixth and seventh transmission lines at one end of the first transmission line and at one end of the second transmission line, respectively.

The first and second variable-length transmission lines may have electrical lengths that satisfy $-\alpha/2 + n_1 \times 180°$ when the first switch is OFF and $\alpha/2 + n_2 \times 180°$ when the first switch is ON ($\alpha = 2\tan^{-1}\{Z_s/Z_0 \tan(\triangle\phi/2)\}$ where $Z_s$ is a characteristic impedance of the first and second variable-length transmission lines, $Z_0$ is a characteristic impedance of the sixth and seventh transmission lines, $\triangle\phi$ is a phase shift amount, and $n_1$ and $n_2$ are arbitrary integers).

The first and second variable-length transmission lines may have electrical lengths that satisfy $\alpha/2$ when the first switch is OFF and $-\alpha/2 + 180°$ when the first switch is ON ($\alpha = 2\tan^{-1}\{Z_s/Z_0 \tan(\triangle\phi/2)\}$ where $Z_s$ is a characteristic impedance of the first and second variable-length transmission lines, $Z_0$ is a characteristic impedance of the sixth and seventh transmission lines, and $\triangle\phi$ is a phase shift amount).

The first and third transmission lines may have the same electrical length.

The first transmission line may have an electrical length of 90°, and the third transmission line may have an electrical length of 90°.

The switching means may be constituted by second and third switches connected to the two ends of the first transmission line, and fourth and fifth switches connected to the two ends of the third transmission line, and may selectively connect the first or third transmission line to the second transmission line by switching the switches in an interlocked manner.

The switching means may be constituted by sixth and seventh switches connected between one end of the first transmission line and two ends of the second transmission line, and may selectively connect the first transmission line to either one of the two ends of the second transmission line.

The transmission lines may be either microstrip lines, slot lines, coplanar lines, or coaxial lines.

The switches may be either PIN diodes, FETs, or micromachine switches.

The phase shifter may be bent at a right angle and mounted on a dielectric board.

With the above arrangement, according to the present invention, as a switched line type phase shifter and a loaded line type phase shifter share part of their transmission lines, the area where the phase shifter is installed can be decreased while operating a phase shifter of 180° and a phase shifter of $\triangle\phi$ independently of each other. This is effective in downsizing an apparatus, such as a phase array antenna, which controls a phase. If the phase shifter is bent at a right angle, it can be installed on the corner of a board efficiently.

Brief Description of Drawings

Fig. 1 is a plan view showing the first embodiment of the present invention;
Fig. 2 is a plan view showing a general loaded line type phase shifter;
Fig. 3 is a plan view showing a loaded line type phase shifter that implements a phase shift amount $\triangle\phi$;

Fig. 4 is a view for explaining a circuit configuration equivalent to that of Fig. 3;

Fig. 5 is a view for explaining a circuit configuration equivalent to that of Fig. 3;

Figs. 6(a) and 6(b) are views for respectively explaining a "state I" with a phase shift amount of $\pm\,\alpha$, / 2 and a "state II" with a phase shift amount of - 180° $\pm\,\alpha$ / 2 in a switching line unit 7 according to claim Fig. 1;

Figs. 7(a) and 7(b) are views for respectively explaining circuit configurations, equivalent to those shown in Fig. 6, in the "state I" and "state II";

Fig. 8 is a view for explaining the operation point of a phase shifter according to Fig. 1;

Fig. 9 is a block diagram showing a 4-bit phase shifter using the phase shifter according to Fig. 1;

Figs. 10(a) and 10(b) are views for respectively explaining dead spaces in a prior art and in this embodiment in comparison;

Fig. 11 shows plan views of the second embodiment of the present invention;

Figs. 12(a) and 12(b) are views for respectively explaining dead spaces in the prior art and in this embodiment in comparison;

Fig. 13 shows views for explaining the third embodiment of the present invention;

Fig. 14 shows plan views of examples of stubs formed by combining transmission lines with different characteristic impedances;

Fig. 15 is a plan view showing the fourth embodiment of the present invention;

Fig. 16 is a plan view showing the fifth embodiment of the present invention;

Fig. 17 is a block diagram showing a conventional 4-bit phase shifter; and

Fig. 18 is a block diagram showing the basic arrangement of the present invention.

Best Mode of Carrying Out the Invention

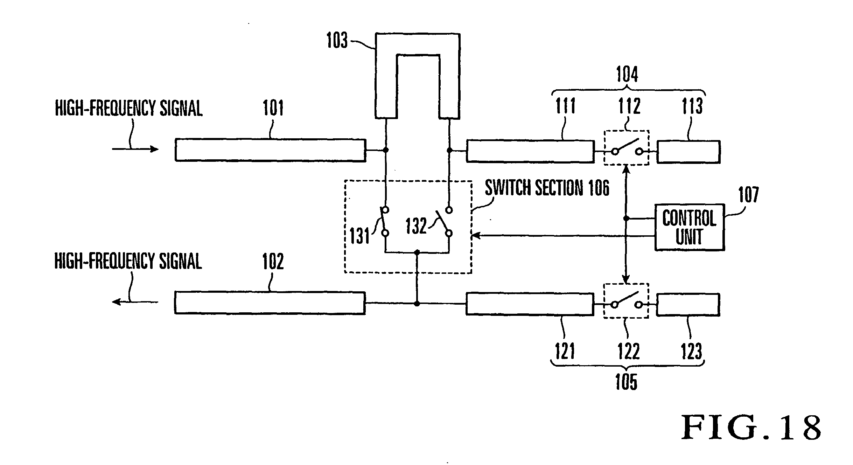

A phase shifter according to the present invention is summarized in the following arrangement. Fig. 18 is a block diagram showing the basic arrangement of the present invention.

The phase shifter shown in Fig. 18 is comprised of input/output transmission lines 101 and 102, a first fixed-length transmission line 103, first and second variable-length transmission lines 104 and 105, a switch unit 106, and a controller 107.

The input/output transmission lines 101 and 102 are arranged such that their ends are apart from each other. Of the separated ends, the end of the input/output transmission line 101 is connected to one end of the fixed-length transmission line 103, and the other end of the fixed-length transmission line 103 is connected to the first variable-length transmission line 104. The fixed-length transmission line 103 is a line with an electrical phase length, i.e., an electrical length, of 180°.

The end of the input/output transmission line 102 is connected to the second variable-length transmission line 105. The first and second. variable-length transmission lines 104 and 105 respectively have first switches 112 and 122. When the switches 112 and 122 are ON/OFF-controlled, the electrical lengths of the variable-length transmission lines 104 and 105 switch with each other. In this embodiment, as the variable-length transmission lines 104 and 105, those of a type that utilize a change in reactance of an open stub are shown. However, the present invention is not limited to them. Reference numerals 111, 113, 121, and 123 denote transmission lines with predetermined electrical lengths.

One or the other end of the fixed-length transmission line 103 is connected to the end of the input/output transmission line 102 through the switch unit 106. The switch unit 106 includes at least two switches 131 and 132. Of the two switches, the switch 131 is connected between one end of the fixed-length transmission line 103 and the end of the input/output transmission line 102, and the switch 132 is connected between the other end of the fixed-length transmission line 103 and the end of the input/output transmission line 102.

The controller 107 is connected to the inputs of the switches 112 and 122 of the variable-length transmission lines 104 and 105 and the inputs of the switches 131 and 132 of the switch unit 106. The controller 107 turns ON/OFF-controls the switches 112, 122, 131, and 132.

When the controller 107 complimentarily drives the switches 131 and 132, the end of the input/output transmission line 102 is switched to be connected to one or the other end of the fixed-length transmission line 103. Thus, a phase shift amount of 0° or 180° can be given to an RF signal input from the input/output transmission line 101. In this manner, the fixed-length transmission line 103 and switch unit 106 constitute a switched line type phase shifter.

When the controller 107 drives the switches 112 and 122 in an interlocked manner, the electrical lengths of the variable-length transmission lines 104 and 105 can be switched in an interlocked manner. Thus, an arbitrary phase shift amount ($\triangle\phi$) can be given to the RF signal described above. In this manner, the variable-length transmission lines 104 and 105 constitute a loaded line type phase shifter with the arbitrary phase shift amount ($\Delta\phi$). When the switch 131 of the switch unit 106 is ON, a stub constituted by the fixed-length transmission line 103 and variable-length transmission line 104 and a stub constituted by the variable-length transmission line 105 are loaded on the main line constituted by the input/output transmission lines 101 and 102 and switch 131. The electrical lengths of these two stubs are equivalent, as will be described later.

In this manner, the phase shifter shown in Fig. 18 is a combination of the switched line type phase shifter with the phase shift amount of 180° and the loaded line type phase shifter with the arbitrary phase shift amount ($\triangle\phi$). The characteristic feature of this structure resides in that these two phase shifters can be operated as independent phase shifters.

The embodiments of the present invention will be described in detail with reference to the accompanying drawings.

[First Embodiment]

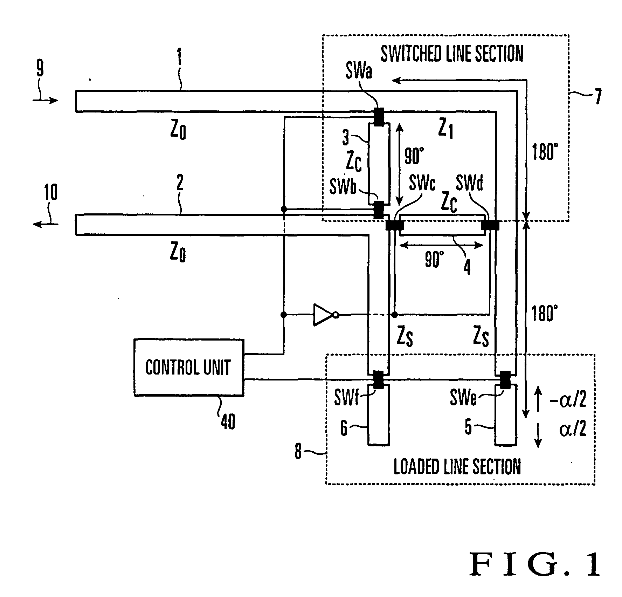

Fig. 1 is a plan view showing the first embodiment of the present invention. As shown in Fig. 1, an L-shaped transmission line 1, an L-shaped transmission line 2 parallel to the transmission line 1, transmission lines 3 and 4 perpendicular to the transmission lines 1 and 2, and transmission lines 5 and 6 are disposed on a dielectric board (not shown). The transmission lines 5 and 6 are so-called open stubs the terminal ends of which are not connected to ground terminals or the like. The lengths of these transmission lines are expressed by an electrical phase length (e. g., 180° corresponds to a half wave). As the practical examples of the transmission lines, microstrip lines, slot lines, coplanar lines, coaxial lines, and the like are used. In this embodiment, microstrip lines are used.

A switch SWa is disposed between the transmission lines 1 and 3. A switch SWb is disposed between the transmission lines 3 and 2. A switch SWc is disposed between the transmission lines 2 and 4. A switch SWd is disposed between the transmission lines 4 and 1. A switch SWe is disposed between the transmission lines 1 and 5. A switch SWf is disposed between the transmission lines 2 and 6. The switches SWa to SWf can be opened/closed by applying predetermined control signals to them. As the practical examples of the switches SWa to SWf, PIN diodes, FETs, micromachine switches, and the like are used when microstrip lines are used as the transmission lines.

The switches SWa to SWf are connected to a controller 40 which applies control signals to them. The controller 40 need not be formed on the dielectric board where the transmission lines 1 to 6 are disposed.

Part of the transmission line 1 (a line portion corresponding to an electrical length of 180°), the transmission lines 3 and 4, and the switches SWa, SWb, SWc, and SWd constitute a switching line unit 7. Similarly, part of the transmission line 1, the transmission lines 5 and 6, and the switches SWe and SWf constitute a loaded line unit 8.

In this manner, this embodiment is a combination of the switched line type phase shifter (switching line unit 7) with the phase shift amount of 180° and the loaded line type phase shifter (loaded line unit 8) with the arbitrary phase shift amount ($\triangle\phi$). The characteristic feature of this structure resides in that these two phase shifters can be operated as independent phase shifters. Therefore, an RF input signal 9 is phase-adjusted by 180° with the switching line unit 7, is phase-adjusted by the arbitrary phase shift amount ($\triangle\phi$) with the loaded line unit 8, and is then output as an output signal 10.

The operation principle of the phase shifter according to Fig. 1 will be described.

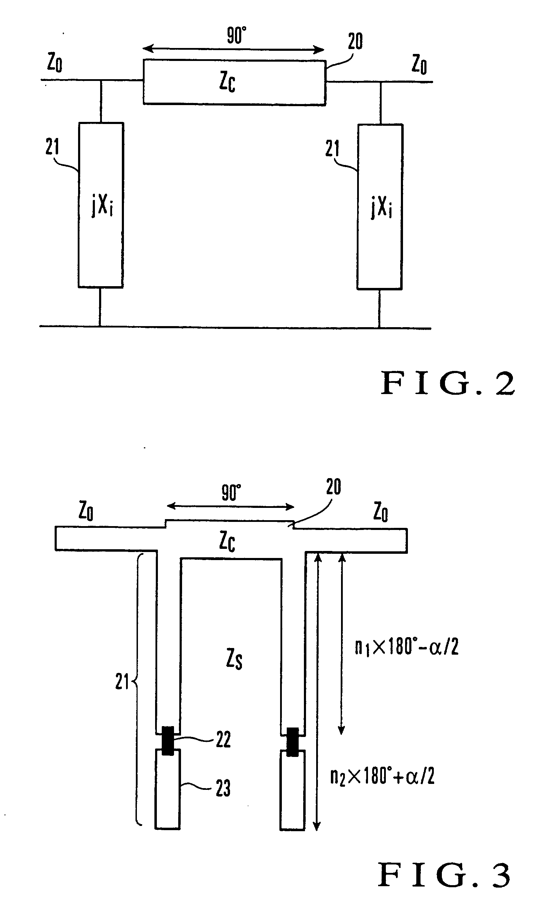

Fig. 2 shows the circuit configuration of a general loaded line type phase shifter. As shown in Fig. 2, this circuit is constituted by two transmission lines 21 connected to a transmission line 20. The transmission lines 21 both have reactances $X_j$, and the transmission line 20 between them is a transmission line with an arbitrary electrical length. In the following description, 90° is used as an electrical length that has the minimum transmission loss. i = 1, 2 indicates two states. The reactance $X_j$ and a characteristic impedance $Z_c$ are given by the following equations:

$$Z_c = Z_0 \cos(\triangle\phi/2) \tag{1}$$

$$X_1 = Z_0 \cot(\triangle\phi / 2) \tag{2}$$

$$X_2 = Z_0 \cot(- \triangle\phi / 2) \tag{3}$$

where $Z_0$ is the characteristic impedance of the transmission line 20.

The reactance $X_j$ of the open stub is given as follows depending on its length $\theta_i$:

$$X_1 = -Z_s \cot(\theta_1) \tag{4}$$

$$X_2 = - Z_s \cot(\theta_2) \tag{5}$$

where Z is the characteristic impedance of the transmission lines 21 as the open stubs.

When equations (2) to (5) are solved, lengths $\theta_1$ and $\theta_2$ of the open stubs in the respective states can be obtained as follows:

$$\theta_1 = -\alpha/2 + n_1 \times 180° \tag{8}$$

$$\theta_2 = \alpha / 2 + n_2 \times 180° \tag{9}$$

$$\alpha = 2\tan^{-1}\{Z_s/Z_0\tan(\triangle\phi/2)\} \tag{10}$$

where $n_1$ and $n_2$ are arbitrary integers, and the right and left open stubs may have different lengths as far as they are multiples of 180°.

When equations (8) and (9) are satisfied, passing phases $\phi1$ and $\phi2$ are as follows:

$$\phi1 = 90° + \Delta\phi / 2$$

$$\phi2 = 90° - \Delta\phi / 2$$

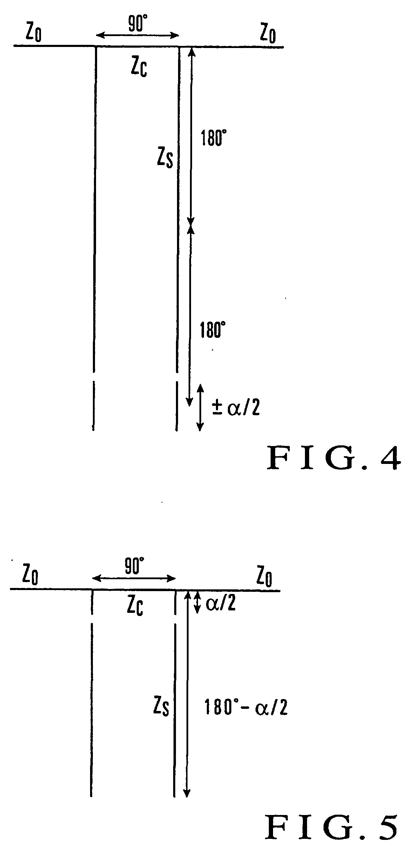

In this manner, the phase shift amount $\triangle\phi$ can be obtained by adjusting the lengths of the open stubs to satisfy equations (8) and (9). When the phase shifter is constituted on the basis of the above description, an arrangement as shown in Fig. 3 is obtained. Switches 22 are switched to appropriately connect/disconnect transmission lines 23, so that the lengths of the whole stubs are changed, thereby providing a variable-length line. This variable-length line implements the phase shift amount $\triangle\phi$ by switching its line length. As shown in Fig. 4, if $\theta_1 = 360° -\alpha/2$ and $\theta_2 = 360° + \alpha/2$, the resultant circuit becomes equivalent to that shown in Fig. 3. As shown in Fig. 5, $\theta_1 = \alpha/2$ and $\theta_2 = 180° - \alpha/2$ are also acceptable.

When several switches and transmission lines are added to the loaded line type phase shifter described above, the 2-bit phase shifter shown in Fig. 1 can be implemented. This will be described.

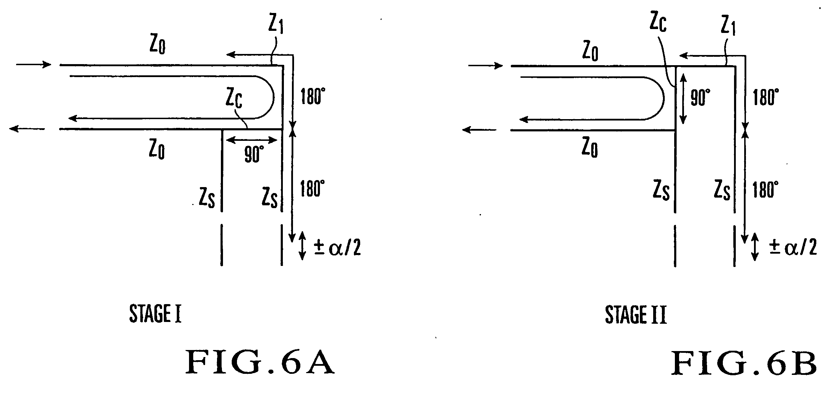

Figs. 6(a) and 6(b) are views for respectively explaining a "state I" and "state II" in the circuit configuration shown in Fig. 1. The switching line unit 7 in Fig. 1 is constituted by the four switches SWa to SWd and transmission lines 1, 2, 3, and 4. Two states can be set by switching the switches SWa to SWd. The switches SWa, SWb, SWc, and SWd are interlocked with each other. When (SWa, SWb, SWc, SWd) = (OFF, OFF, ON, ON), the "state I" can be obtained. When (SWa, SWb, SWc, SWd) = (ON, ON, OFF, OFF), the "state II" can be obtained. With this switching operation, the circuit in the "state I" becomes equivalent to that shown in Fig. 6(a). Similarly, the circuit configuration in the "state II" becomes as shown in Fig. 6(b). As is apparent from Figs. 6(a) and 6(b), a state change from the "state I" to the "state II" or from the "state II" to the "state I" implements the phase shift amount of 180°.

The loaded line unit 8 is constituted by the two switches SWe and SWf and transmission lines 1, 2, 5, and 6. The phase shift amount $\triangle\phi$ can be implemented by switching the switches SWe and SWf in an interlocked manner. When (SWe, SWf) = (ON, ON), a "state L" can be obtained. When (SWe, SWf) = (OFF, OFF), a "state S" can be obtained. The loaded line unit 8 serves as a loaded line type phase shifter and implements the phase shift amount $\triangle\phi$.

These "state I", "state II", "state L", and "state S" can be operated independently of each other. Accordingly, the phase shifter shown in Fig. 1 has 4 (= 2 x 2) states (that is, the state IL", "state IS", "state IIL", and "state IIS").

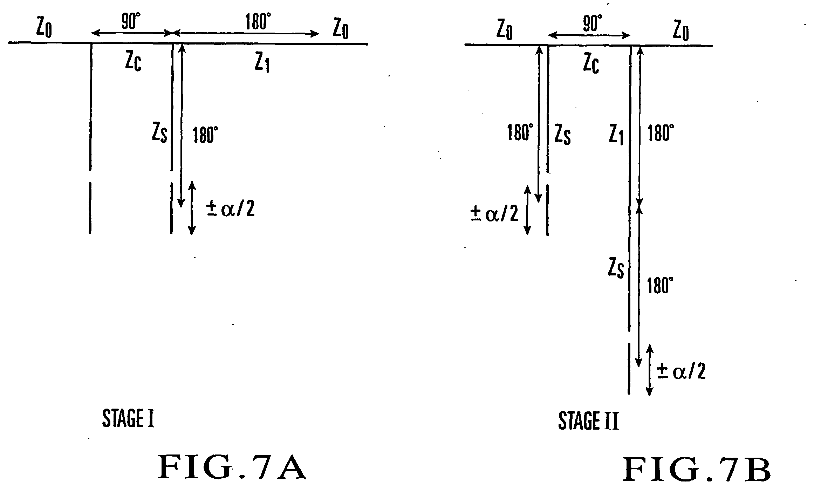

Figs. 7(a) and 7(b) show circuit configurations equivalent to those in the "state I" and "state II" of Fig. 6. As shown in Fig. 7(a), the circuit in the "state I" is equivalent to that obtained by adding a line of 180° to a loaded line type phase shifter of $\triangle\phi$. Accordingly, the circuit in the "state I" serves as one obtained by adding a delay of 180° to a phase shifter with a phase shift amount $\triangle\phi$. Consequently, the passing phases $\phi1$ and $\phi2$ are expressed as:

$$\phi1 = 90° + \triangle\phi / 2 - 180°$$

$$\phi 2 = 90° - \triangle\phi / 2 - 180°$$

and the phase shift amount obtained by switching the open stubs is expressed as:

$$\Delta\phi = \phi 1 - \phi 2$$

As shown in Fig. 7(b), the circuit in the "state II" serves as a phase shifter with right and left stubs that are asymmetrical. Although the electrical lengths of the two stubs differ, this phase shifter serves as a phase shifter with the phase shift amount $\Delta\phi$. This is because the lengths of the stubs $\theta$ become periodically equivalent, as indicated by equations (8) and (9). Therefore, when the open stubs are switched, the phase shift amount $\triangle\phi$ can be implemented. The passing phases $\phi 1$ and $\phi 2$ are expressed as:

$$\phi 1 = 90° + \Delta\phi / 2$$

$$\phi 2 = 90° - \Delta\phi / 2$$

and the phase shift amount obtained by switching the open stubs is expressed as:

$$\Delta\phi = \phi 1 - \phi 2$$

In this manner, the basic difference between the "state I" and "state II" resides only in the presence/absence of the line of 180° inserted in the main line in the "state I".
The operating points of the phase shifter shown in Fig. 1 will be described. Note that $\triangle\phi = 45°$.

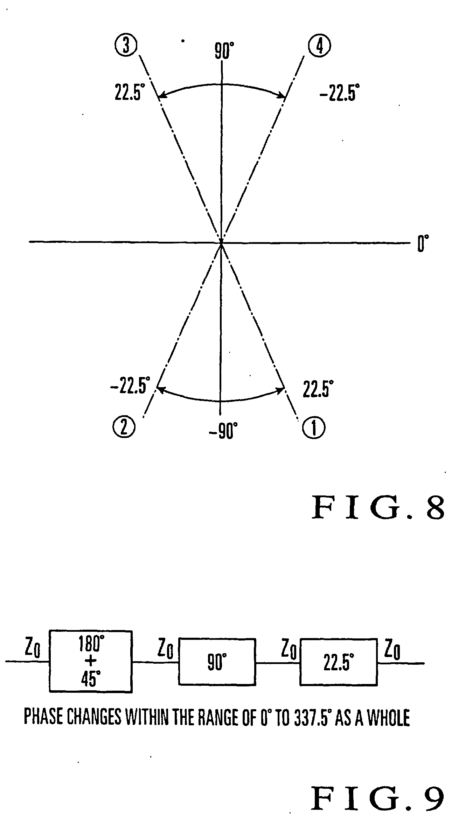

Fig. 8 is a view for explaining the operating points of the phase shifter according to Fig. 1. Table 1 shows the operating point of the phase shifter according to Fig. 1. Numerals (① to④ ) in Fig. 8 and Table 1 indicate the respective operating points. In this phase shifter, the switching line unit 7 switches between ① and ③ , and between ② and ④ , so that a phase shift amount of 180° can be obtained. Also, the loaded line unit 8 switches between ①  and ② , and between ③  and ④ , so that a phase shift amount of 45° can be obtained. As the switching line unit 7 and loaded line unit 8 operate independently of each other, they respectively serve as 2-bit phase shifters with the phase shift amounts of 180° and 45°.

**[Table 1]**

| | | Loaded Line Unit 8 | |
|---|---|---|---|
| | | L | S |
| Switching Line Unit 7 | I | 90° + 22.5° ① − 180° | 90° − 22.5° ② − 180° |
| | II | 90° + 22.5° ③ 0° | 90° − 22.5° ④ 0° |

Note that the upper line of each column indicates a passing phase obtained by the loaded line unit 8, and that the lower line thereof indicates a passing phase obtained by the switching line unit 7.
As described above, in this embodiment, since the switching line unit 7 and loaded line unit 8 share the transmission line 4 and the like, the area occupied by the board can be reduced when compared to a conventional case wherein two phase shifters are cascade-connected. Since the whole phase shifter is bent at a right angle, it can be efficiently installed on the corner of the board. Also, the number of switched to be used can be the same as in the conventional case.

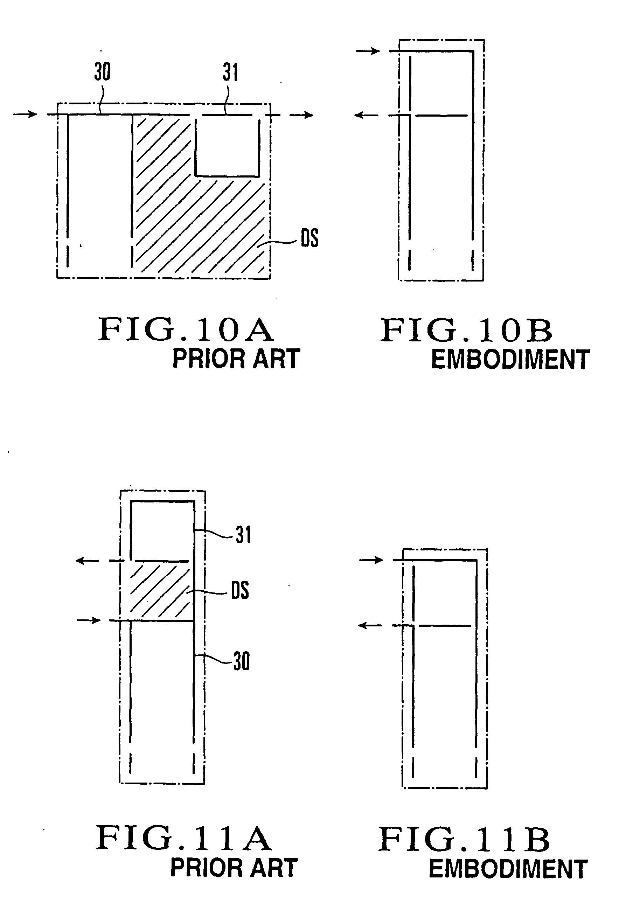

Fig. 9 is a block diagram showing a 4-bit phase shifter using the phase shifter according to Fig. 1. As shown in Fig. 9, when a phase shifter of 180° and a phase shifter of 45° are integrated, the area occupied by them can be reduced. Fig. 10(a) shows a conventional 2-bit phase shifter obtained by combining a loaded line type phase shifter 30 with a phase shift amount of 45° and a switched line type phase shifter 31 with a phase shift amount of 180°. Fig. 10(b) shows the phase shifter of Fig. 1 which implements phase shift amounts of 180° and 45°. As is seen from comparison of Figs. 10(a) and 10(b), where a dead space DS forms in the prior art, it does not in this embodiment.

The phase shifter shown in Fig. 10(a) may be modified as shown in Fig. 11(a). When the arrangement of the switched line type phase shifter 31 is changed in this manner, the directions of the input and output signals can be set in the same manner as in this embodiment. Even in this case, the dead space DS cannot be eliminated in the prior art. This proves how effective this embodiment is in reducing the layout area.

Other embodiments of the present invention will be described.

[Second Embodiment]

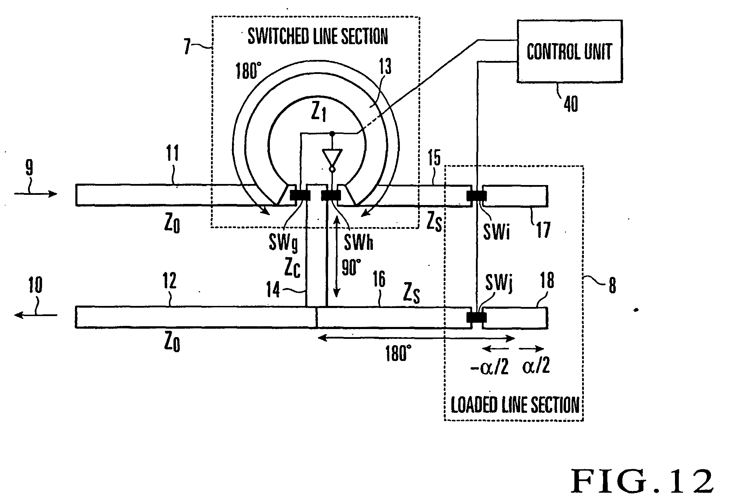

Fig. 12 is a plan view showing the second embodiment of the present invention. In the first embodiment, the switching line unit 7 uses four switches and the two transmission lines 3 and 4 to perform switching operation. The present invention is not limited to this arrangement, but switching operation can also be performed by using two switches and one transmission line.

The transmission lines can be implemented by microstrip lines, slot lines, coplanar lines, coaxial lines, or the like, in the same manner as in the first embodiment. In the second embodiment, microstrip lines are used as an example. As the switches, PIN diodes, FETs, or micromachine switches are utilized. A transmission line 13 (with an electrical length of 180°) and switches SWg and SWh constitute a switching line unit 7. Similarly, part of transmission lines 15 and 16, transmission lines 17 and 18, and switches SWi and SWj constitute a loaded line unit 8.

This embodiment has a combination of a switched line type phase shifter (switching line unit 7) with a phase shift amount of 180° and a loaded line type phase shifter (loaded line unit 8) with an arbitrary phase shift amount ($\triangle\phi$). The characteristic feature of this structure resides in that these two phase shifters can be operated as independent phase shifters. Therefore, an RF input signal is phase-adjusted by 180° with the switching line unit 7, phase-adjusted by the arbitrary phase shift amount ($\triangle\phi$) with the loaded line unit 8, and then output as an output signal.

The operating principle of the phase shifter according to Fig. 12 will be described.

In this embodiment, the switching line unit 7 is constituted by the two switches SWg and SWh and transmission line 13. Two states can be set by switching the switches SWg and SWh. The switches SWg and SWh are interlocked with each other. When (SWg, SWh) = (OFF, ON), a "state I" can be obtained. When (SWg, SWh) = (ON, OFF), a "state II" can be obtained. This circuit configuration is equivalent to that of the first embodiment shown in Fig. 6. With the switching operation, the circuit in the "state I" becomes equivalent to that shown in Fig. 6(a). Similarly, the circuit configuration in the "state II" becomes equivalent to that shown in Fig. 6(b). As is apparent from Figs. 6(a) and 6(b), a state change from the "state I" to the "state II" or from the "state II" to the "state I" implements the phase shift amount of 180°.

The loaded line unit 8 is constituted by the two switches SWi and SWj and the transmission lines 15, 16, 17, and 18. A phase shift amount $\triangle\phi$ can be implemented by switching the switches SWi and SWj in an interlocked manner. When (SWi, SWj) = (ON, ON), a "state L" can be obtained. When (SWi, SWj) = (OFF, OFF), a "state S" can be obtained. The loaded line unit 8 serves as a loaded line type phase shifter and implements the phase shift amount $\triangle\phi$, in the same manner as in the first embodiment.

According to this embodiment, since the switching line unit 7 can be constituted by two switches and one transmission line, the phase shifter can be made more compact when compared to the arrangement shown in Fig. 1. The shape of the transmission line 13 is not limited to be round as shown in Fig. 12, but can be rectangular or the like.

[Third Embodiment]

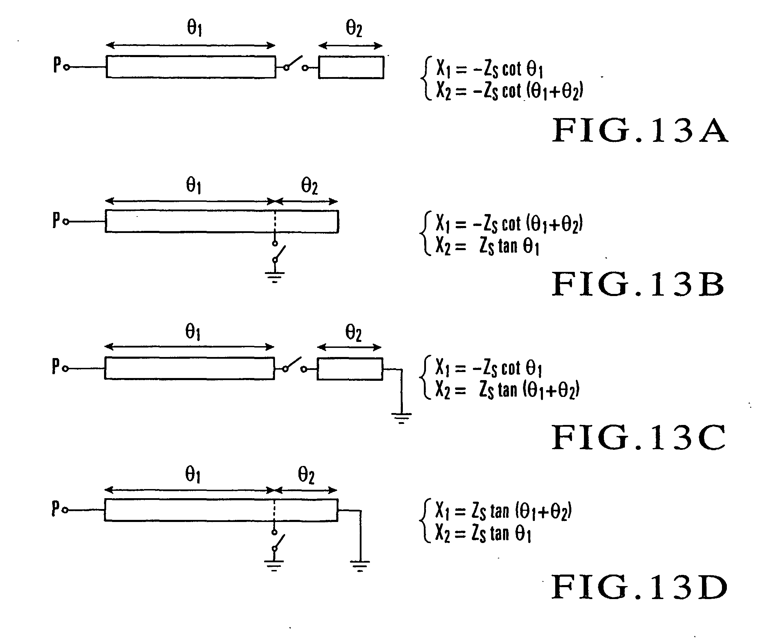

In the phase shifter shown in Fig. 1, the reactance of the open stub as shown in Fig. 13 (a) is utilized in order to implement a loaded line type phase shifter in the loaded line unit 8. If a desired reactance can be obtained in the loaded line unit 8, other schemes can be employed. For example, a short stub may be formed when the switch is ON, and an open stub may be formed when the switch is OFF, as shown in Figs. 13(b) and 13(c), and a loaded line type phase shifter may be formed by utilizing the reactances of these stubs. Alternatively, as shown in Fig. 13(d), a loaded line type phase shifter may be formed by utilizing the reactance of a short stub.

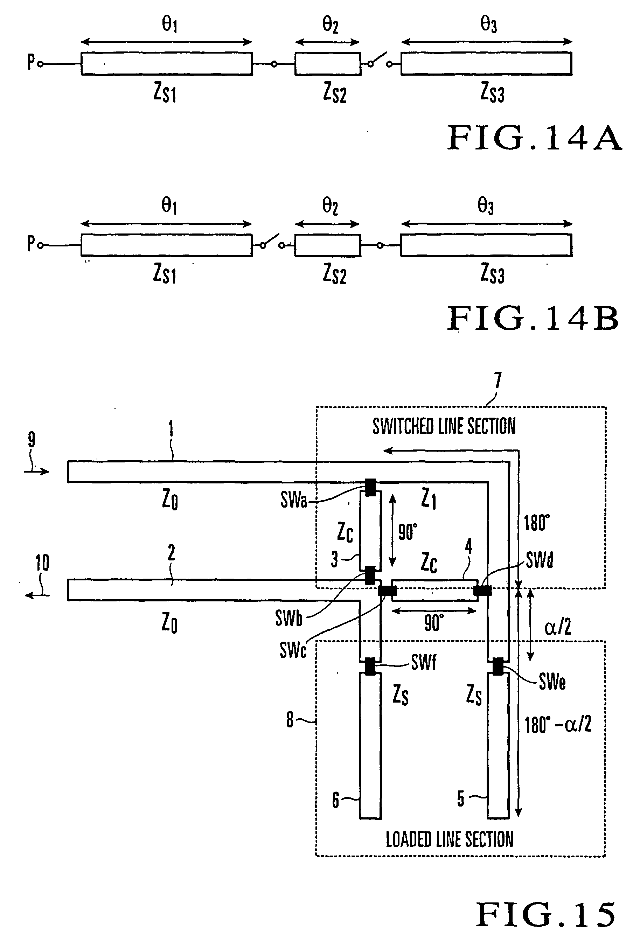

Reference symbols $X_1$ and $X_2$ indicate reactances obtained on the right side of a point P when the switch is ON and OFF, respectively. For reference, in the case of Fig. 1, the loaded line type phase shifter is implemented by switching the open stub shown in Fig. 13(a). The characteristic impedance of the stub need not be uniform, and a desired reactance may also be implemented by combining lines with different characteristic impedances, as shown in Fig. 14. Alternatively, a desired reactance may be implemented by using a lumped/distributed element (e.g., a coil, capacitor, or the like) in the loaded line type phase shifter.

[Fourth Embodiment]

Fig. 15 is a plan view showing the fourth embodiment of the present invention. The phase shifter of Fig. 1 implements a loaded line type phase shifter in the loaded line unit 8 and utilizes the reactance of an open stub. In the phase shifter shown in Fig. 13, the circuit shown in Fig. 5 is adopted in a loaded line unit 8. More specifically, the line length of a switching line unit 7 is set to $\alpha/2$, and the line length of the whole open stub is set to $180° - \alpha/2$, so that the stub length can be decreased than in the arrangement shown in Fig. 1. This contributes to further downsizing of the phase shifter. The operating method is identical to that of the example shown in Fig. 1. In Fig. 15, a controller 40 is not shown.

[Fifth Embodiment]

Fig. 16 is a plan view showing the fifth embodiment of the present invention. As shown in Fig. 16, this phase shifter is obtained by slightly modifying the layout of Fig. 1, and is identical to that of Fig. 1 in circuit configuration. In this embodiment, when the phase shifter is installed on the corner of a board, the input and output transmission lines cannot be extended in the same direction, and the layout of the transmission lines can be made more efficiently. The operating method is identical to that of the case shown in Fig. 1. In Fig. 16, a controller 40 is not shown.

Industrial Applicability

The phase shifter according to the present invention can be used in an apparatus such as a phased array antenna, which controls the phase.

**Claims**

**1.** A phase shifter for digitally phase-shifting an RF signal, **characterized by** comprising:

two input/output transmission lines with ends arranged such that ends thereof are apart from each other;
a first fixed-length transmission line with an electrical length of 180° having one end connected to an end of one of said input/output transmission lines;
a first variable-length transmission line connected to the other end of said first fixed-length transmission line;
a second variable-length transmission line connected to an end of the other one of said input/output transmission lines;
first switches respectively included in said first and second variable-length transmission lines to switch electrical lengths of said first and second variable-length transmission lines;
switch means, including at least two switches, for switchingly connecting said end of said other input/output transmission line to one or the other end of said first fixed-length transmission line, so that the RF signal has a phase shift amount of 0° or 180°; and
control means for controlling said first switches included in said first and second variable-length transmission lines and said switches included in said switch means.

**2.** A phase shifter according to claim 1, **characterized in that**

said switch means has
second and third fixed-length transmission lines arranged apart from two ends of said first fixed-length transmission line and from said end of said other input/output transmission line,
a second switch for connecting one end of said second fixed-length transmission line and one end of said first fixed-length transmission line,
a third switch for connecting the other end of said second fixed-length transmission line and said end of said other input/output transmission line,
a fourth switch for connecting one end of said third fixed-length transmission line and said other end of said first fixed-length transmission line, and
a fifth switch for connecting the other end of said third fixed-length transmission line and said end of said other input/output transmission line, and

said control means includes means for complimentarily driving said second and third switches and said fourth and fifth switches included in said switch means.

3. A phase shifter according to claim 1, **characterized in that**

said switch means has
a second fixed-length transmission line with open one end and the other end connected to said end of said other input/output transmission line;
a sixth switch for connecting said one end of said second fixed-length transmission line and said one end of said first fixed-length transmission line, and
a seventh switch for connecting said one end of said second fixed-length transmission line and said other end of said first fixed-length transmission line, and
said control means includes means for complimentarily driving said sixth and seventh switches included in said switch means.

4. A phase shifter for digitally phase-shifting an RF signal, **characterized by** comprising:

first phase shifting means, having a first transmission line, a first variable-length transmission line connected to one end of said first transmission line, a second variable-length transmission line connected to the other end of said first transmission line, and a second transmission line with an electrical length of 180° and connected to said one end of said first transmission lines, for switching line lengths of said first and second variable-length transmission lines at said two ends of said first transmission line, thereby performing phase shifting;
second phase shifting means, having a third transmission line, a series circuit connected to one end of said third transmission line and comprised of said second transmission line and said first variable-length transmission line, and said second variable-length transmission line connected to the other end of said third transmission line, for switching line lengths of said first and second variable-length transmission lines at said two ends of said third transmission line, thereby performing phase shifting; and
switching means for switching said first and second phase shifting means with each other.

5. A phase shifter for digitally phase-shifting an RF signal, **characterized by** comprising:

first phase shifting means, having a first transmission line, a first variable-length transmission line connected to one end of said first transmission line, a second variable-length transmission line connected to the other end of said first transmission line, and a second transmission line with an electrical length of 180° and connected to said one end of said first transmission line, for switching line lengths of said first and second variable-length transmission lines at said two ends of said first transmission line, thereby performing phase shifting;
second phase shifting means, having said first transmission line, a series circuit connected to one end of said first transmission line and comprised of said second transmission line and said first variable-length transmission line, and said second variable-length transmission line connected to the other end of said first transmission line, for switching line lengths of said first and second variable-length transmission lines at said two ends of said first transmission line, thereby performing phase shifting; and
switching means for switching said first and second phase shifting means with each other.

6. A phase shifter according to claim 4, **characterized in that** each of said first and second variable-length transmission lines has a first switch connected between a fourth transmission line and a fifth transmission line with an open distal end.

7. A phase shifter according to claim 4, **characterized in that** each of said first and second varible-length transmission lines has a first switch with one grounded end, which is connected between a fourth transmission line and a fifth transmission line with an open distal end.

8. A phase shifter according to claim 4, **characterized in that** each of said first and second varible-length transmission lines has a first switch connected between a fourth transmission line and a fifth transmission line with a grounded distal end.

9. A phase shifter according to claim 4, **characterized in that** each of said first and second varible-length transmission lines has a first switch with one end grounded, which is connected between a fourth transmission line and a fifth transmission line with a grounded distal end.

**10.** A phase shifter according to claim 4, **characterized in that** said phase shifter further comprises signal input/output sixth and seventh transmission lines at said one end of said first transmission line and at one end of said second transmission line, respectively.

**11.** A phase shifter according to claim 10, **characterized in that** said first and second variable-length transmission lines have electrical lengths that satisfy $-\alpha / 2 + n_1 \times 180°$ when said first switch is OFF and $\alpha / 2 + n_2 \times 180°$ when said first switch is ON ($\alpha = 2\tan^{-1}\{Z_s/Z_0\tan(\triangle\phi/2)\}$ where $Z_s$ is a characteristic impedance of said first and second variable-length transmission lines, $Z_0$ is a characteristic impedance of said sixth and seventh transmission lines, $\triangle\phi$ is a phase shift amount, and $n_1$ and $n_2$ are arbitrary integers).

**12.** A phase shifter according to claim 10, **characterized in that** said first and second variable-length transmission lines have electrical lengths that satisfy $\alpha / 2$ when said first switch is OFF and $-\alpha/2 + 180°$ when said first switch is ON ($\alpha = 2\tan^{-1}\{Z_s/Z_0\tan(\triangle\phi/2)\}$ where $Z_s$ is a characteristic impedance of said first and second variable-length transmission lines, $Z_0$ is a characteristic impedance of said sixth and seventh transmission lines, and $\triangle\phi$ is a phase shift amount).

**13.** A phase shifter according to claim 4, **characterized in that** said first and third transmission lines have the same electrical length.

**14.** A phase shifter according to claim 4, **characterized in that** said first and third transmission lines have electrical lengths of 90°.

**15.** A phase shifter according to claim 5, **characterized in that** said first transmission line has an electrical length of 90°.

**16.** A phase shifter according to claim 4, **characterized in that**

said switching means is constituted by second and third switches connected to said two ends of said first transmission line, and fourth and fifth switches connected to said two ends of said third transmission line, and selectively connects said first or third transmission line to said second transmission line by switching said switches in an interlocked manner.

**17.** A phase shifter according to claim 5, **characterized in that**

said switching means is constituted by sixth and seventh switches connected between one end of said first transmission line and two ends of said second transmission line, and selectively connects said first transmission line to either one of said two ends of said second transmission line.

**18.** A phase shifter according to claim 4, **characterized in that** said transmission lines are either microstrip lines, slot lines, coplanar lines, or coaxial lines.

**19.** A phase shifter according to claim 4, **characterized in that** said switches are either PIN diodes, FETs, or micromachine switches.

**20.** A phase shifter according to claim 4, **characterized in that** said phase shifter is bent at a right angle and mounted on a dielectric board.

FIG. 1

F I G. 2

F I G. 3

$Z_0$ $\qquad$ 90° $\qquad$ $Z_0$

$Z_C$

$Z_S$    180°

180°

$\pm \alpha/2$

# F I G. 4

$Z_0$ $\qquad$ 90° $\qquad$ $Z_0$

$Z_C$    $\alpha/2$

$Z_S$    180°$-\alpha/2$

# F I G. 5

STAGE I

FIG.6A

STAGE II

FIG.6B

STAGE I

$Z_0$  90°  $Z_C$  180°  $Z_1$  $Z_0$

$Z_S$  180°  $\pm \alpha/2$

FIG.7A

STAGE II

$Z_0$  90°  $Z_C$  $Z_1$  180°  $Z_0$

$Z_S$  180°  $\pm \alpha/2$

$Z_S$  180°  $\pm \alpha/2$

FIG.7B

FIG. 8

PHASE CHANGES WITHIN THE RANGE OF 0° TO 337.5° AS A WHOLE

FIG. 9

FIG.10A
PRIOR ART

FIG.10B
EMBODIMENT

FIG.11A
PRIOR ART

FIG.11B
EMBODIMENT

EP 1 160 906 A1

SWITCHED LINE SECTION

7

180°    13

$Z_1$

11

9 →

$Z_0$

CONTROL UNIT

40

15

$Z_S$

SWi    17

SWg    SWh    90°
$Z_C$

14    16    $Z_S$

12

10 ←

$Z_0$

180°

SWj    18

8

$-\alpha/2$    $\alpha/2$

LOADED LINE SECTION

FIG.12

$$\begin{cases} X_1 = -Z_S \cot \theta_1 \\ X_2 = -Z_S \cot (\theta_1+\theta_2) \end{cases}$$

FIG.13A

$$\begin{cases} X_1 = -Z_S \cot (\theta_1+\theta_2) \\ X_2 = Z_S \tan \theta_1 \end{cases}$$

FIG.13B

$$\begin{cases} X_1 = -Z_S \cot \theta_1 \\ X_2 = Z_S \tan (\theta_1+\theta_2) \end{cases}$$

FIG.13C

$$\begin{cases} X_1 = Z_S \tan (\theta_1+\theta_2) \\ X_2 = Z_S \tan \theta_1 \end{cases}$$

FIG.13D

EP 1 160 906 A1

FIG.14A

FIG.14B

FIG.15

FIG.16

PHASE CHANGES WITHIN THE RANGE OF 0° TO 337.5° AS A WHOLE

FIG.17

FIG.18

HIGH-FREQUENCY SIGNAL

101

102

103

104

105

106

107

111

112

113

121

122

123

131

132

SWITCH SECTION 106

CONTROL UNIT

EP 1 160 906 A1

<div style="text-align:center">**INTERNATIONAL SEARCH REPORT**</div>

| International application No. |
| --- |
| PCT/JP99/06485 |

| A. CLASSIFICATION OF SUBJECT MATTER |
| --- |
| Int.Cl⁷ H01P1/18, H03H11/20 |

According to International Patent Classification (IPC) or to both national classification and IPC

| B. FIELDS SEARCHED |
| --- |
| Minimum documentation searched (classification system followed by classification symbols)<br>Int.Cl⁷ H01P1/18 - 1/185<br>H03H7/20, 11/20 |

Documentation searched other than minimum documentation to the extent that such documents are included in the fields searched

| | | | |
| --- | --- | --- | --- |
| Jitsuyo Shinan Koho | 1926-1996 | Jitsuyo Shinan Toroku Koho | 1996-1999 |
| Kokai Jitsuyo Shinan Koho | 1971-1999 | Toroku Jitsuyo Shinan Koho | 1994-1999 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| A | US, 5166648, A (The United States of America as represented by the Secretary of the Air Force), 24 November, 1992 (24.11.92) (Family: none) | 1-20 |
| A | US, 4965866, A (Alcatel N.V.), 23 October, 1990 (23.10.90) & FR, 2636793, A1 & EP, 362583, A1 & JP, 2-121442, A | 1-20 |
| A | US, 4599585, A (Raytheon Co.), 23 April, 1984 (23.04.84) (Family: none) | 1-20 |
| A | US, 4070639, A (International Telephone and Telegraph Corp.), 24 January, 1978 (24.01.78) (Family: none) | 1-20 |
| A | JP, 5-335802, A (Mitsubishi Electric Corporation), 17 December, 1993 (17.12.93) (Family: none) | 1-20 |
| A | JP, 5-251903, A (TECH. RES. & DEV. INST. OF JAPAN DEF. AGENCY), 28 September, 1993 (28.09.93) (Family: none) | 1-20 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 28 December, 1999 (28.12.99) | 18.01.00 |

| Name and mailing address of the ISA/<br>Japanese Patent Office | Authorized officer |
| --- | --- |
| Facsimile No. | Telephone No. |

Form PCT/ISA/210 (second sheet) (July 1992)

## INTERNATIONAL SEARCH REPORT

| | International application No. |
|---|---|
| | PCT/JP99/06485 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP, 5-63101, U (Mitsubishi Electric Corporation), 20 August, 1993 (20.08.93)   (Family: none) | 1-20 |

Form PCT/ISA/210 (continuation of second sheet) (July 1992)